# DEMANDE DE BREVET EUROPEEN

(11) **EP 1 028 537 A1**
(43) Date de publication de la demande: **16.08.2000**
(21) Numéro de dépôt: 00400261.4
(22) Date de dépôt: 31.01.2000
(51) Int. Cl.: H04B 1/30, H04B 1/16, H03D 11/00

(54) **Recepteur Rf tres faible consommation et faible cout**

(30) Priorité: 12.02.1999 FR 9901712
(71) Demandeur: VALEO ELECTRONIQUE, 94042 Creteil Cédex (FR)
(72) Inventeur: Farine, Herve, 94210 La Varenne St. Hilaire (FR)
(74) Mandataire: Rosolen, Katell

(57) **Abrégé**

Récepteur radio-fréquence comportant un oscillateur (1) qui comprend un transistor (T1) qui est commandé par la superposition d'un signal périodique de commande (Q) qui déclenche périodiquement le démarrage puis la disparition des oscillations de l'oscillateur (1), ainsi que d'un signal haute fréquence (RF) à détecter, caractérisé en ce que le signal périodique (Q) ne commande le transistor que pendant des fenêtres temporelles, qui sont séparées entre elles par des intervalles de temps d'une durée plus importante pendant lesquels le transistor est bloqué.

## Description

La présente invention est relative à un récepteur radio-fréquence basse consommation.

L'invention trouve notamment application dans tous les systèmes sans fil nécessitant un récepteur radio-fréquence de faible consommation et de faible coût.

En particulier, elle trouve avantageusement application dans les systèmes de télécommande à distance qui permettent de réaliser le verrouillage/déverrouillage "mains libres" d'ouvrants de véhicules automobiles (portières, coffre), c'est à dire un verrouillage/déverrouillage sans actionnement d'un boitier de télécommande par l'opérateur.

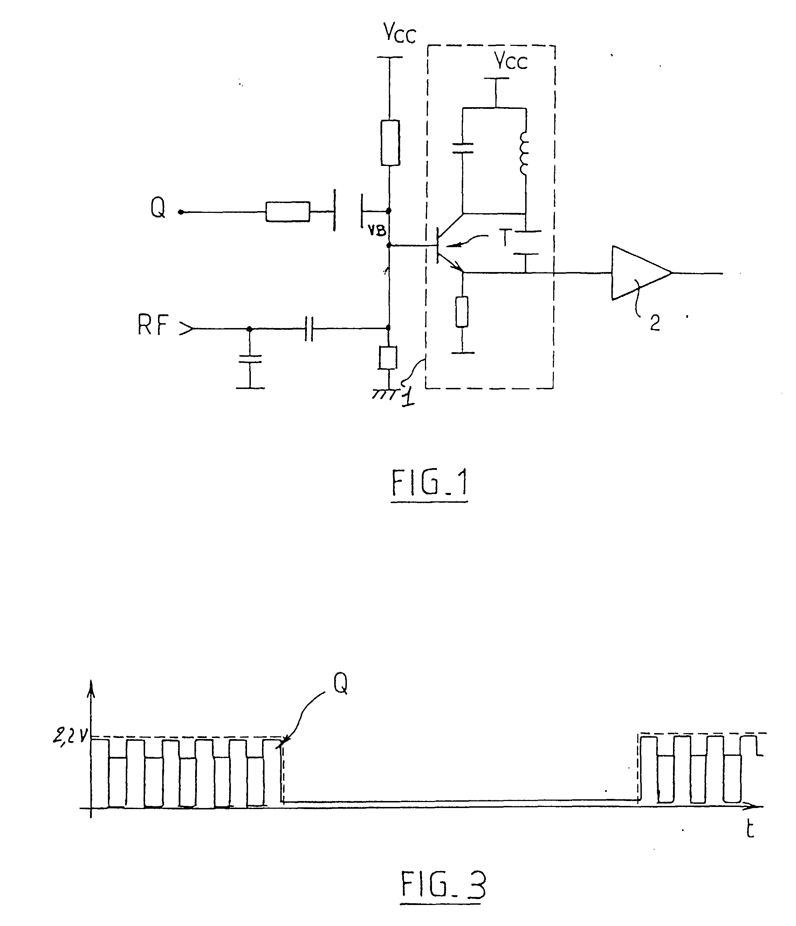

On connaît depuis longtemps des récepteurs présentant une structure dite à "super-réaction" comportant, ainsi qu'illustré sur la figure 1, un oscillateur 1 qui reçoit en entrée un signal RF haute fréquence qui est modulé en amplitude (modulation ASK ou OOK, par exemple).

Cet oscillateur 1 est allumé puis éteint au rythme d'un signal Q périodique appelé signal "quench" qui est d'une fréquence de l'ordre de 300 KHz à 1 MHz. Ce signal quench est superposé au signal RF et est injecté avec celui-ci sur la base d'un transistor T qui est intégré à l'oscillateur 1 et qui est pré-polarisé.

Le signal quench peut être généré par un oscillateur indépendant (on parle alors d'un montage à quench externe) ou être généré par la relaxation de l'oscillateur 1 (on parle alors d'un montage auto quench).

Avec un montage à quench externe, l'amplitude du signal en sortie de l'oscillateur 1 est proportionnelle à l'énergie du signal RF d'entrée. Avec les montages à auto-quench, la fréquence d'allumage/extinction varie avec l'énergie du signal RF d'entrée.

Dans l'un et l'autre cas, le signal démodulé est restitué par un amplificateur 2 basse fréquence en sortie du montage.

Ce type de récepteur est très répandu et répond à la plupart des besoins des récepteurs fonctionnant en veille permanente pour recevoir des signaux modulés en amplitude avec un débit moyen de 1 à 2 Kbit/s.

Il présente l'avantage d'être d'un faible coût et d'une consommation faible par rapport aux récepteurs homodynes ou super hétérodynes.

Toutefois, les récepteurs à quench externe ou à auto-quench connus à ce jour sont alimentés sous une tension de 2 à 5 volts et présentent une consommation en courant de l'ordre de 100 à 400 µA.

Or, pour certaines applications, il est souhaitable de disposer de récepteurs présentant une consommation de courant très inférieure (de 10 à 60 fois moins).

Par ailleurs, ces récepteurs ont des temps d'établissement de l'ordre de la milliseconde ce qui impose, pour réduire la consommation, d'utiliser des périodes d'échantillonnage importantes. De ce fait, ils ne permettent pas des temps de réaction suffisamment satisfaisants notamment pour les applications de télécommande mains libres.

Un but de l'invention est de proposer un récepteur radio-fréquence qui présente une consommation beaucoup plus faible que les récepteurs à super-réaction connus à ce jour, tout en étant en permanence sous tension et en permettant des temps de réaction courts.

L'invention propose quant à elle un récepteur radio-fréquence comportant un oscillateur qui comprend un transistor qui est commandé par la superposition d'un signal périodique de commande qui déclenche périodiquement le démarrage puis la disparition des oscillations de l'oscillateur, ainsi que d'un signal haute fréquence à détecter, caractérisé en ce que le signal périodique ne commande le transistor que pendant des fenêtres temporelles, qui sont séparées entre elles par des intervalles de temps d'une durée plus importante pendant lesquels le transistor est bloqué.

Un tel récepteur est avantageusement complété par les différentes caractéristiques suivantes prises seules ou selon toutes leurs combinaisons possibles :
- le signal périodique de commande est généré par des moyens externes à l'oscillateur ;
- le transistor est polarisé par le signal périodique de commande ;
- le signal périodique de commande est une tension dont le niveau moyen est de 1 Volts ;
- les variations du signal de commande sont inférieures à ± 50 mV autour de 2 V ;
- il comporte un filtre passe haut en sortie de l'oscillateur ;
- il comporte des moyens formant démodulateur en sortie du filtre passe-haut ;
- il comporte un circuit numérique qui réalise la génération du signal de commande ;
- une fenêtre temporelle a une durée de l'ordre 100 µs, un intervalle de temps entre deux fenêtres temporelles ayant une durée de l'ordre de 6 ms.

L'invention concerne également un dispositif pour la commande « mains libres », à distance, du verrouillage et/ou déverrouillage d'au moins un ouvrant de véhicule automobile, comportant des moyens pour l'émission d'un signal qui porte un code destiné à être authentifié par des moyens de réception sur le véhicule, ce dispositif comportant un récepteur du type précité.

D'autres caractéristiques et avantages de l'invention ressortiront encore de la description qui suit. Cette description est purement illustrative et non limitative. Elle doit être lue en regard des dessins annexés sur lesquels :
- la figure 1, déjà analysée, représente schématiquement un récepteur à super-réaction conforme à un mode de réalisation de l'état de la technique ;
- la figure 2 est un graphe sur lequel on a illustré le signal de commande.
- la figure 3 est une représentation schématique d'un récepteur conforme à un mode de réalisation possible pour l'invention ;

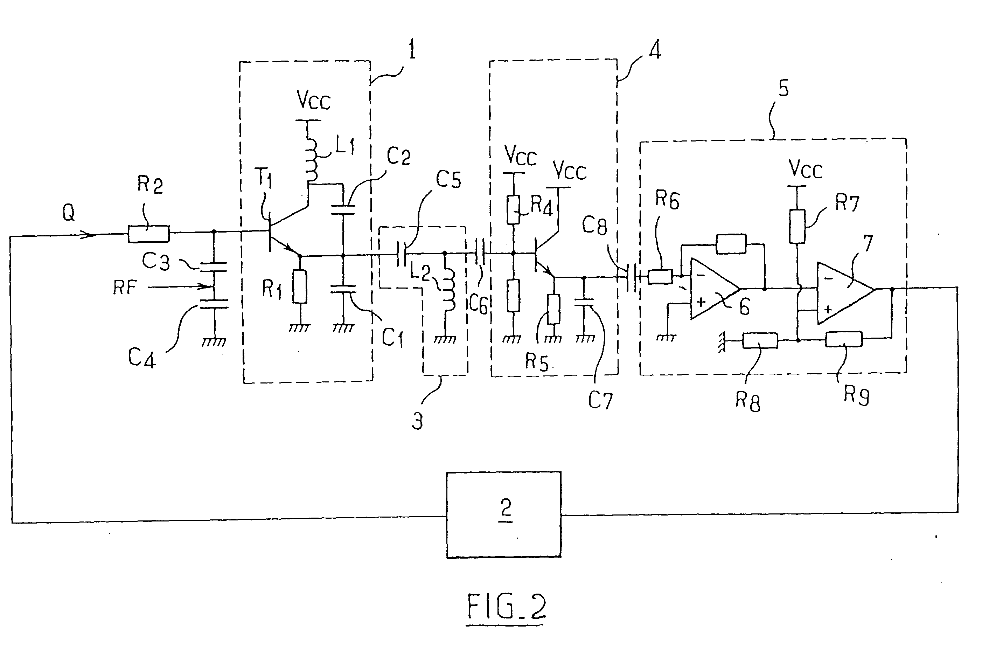

Le récepteur représenté sur la figure 2 comporte un oscillateur 1 qui intègre un transistor d'entrée T1 qui est commandé par une tension qui est la superposition d'un signal RF à détecter et démoduler (par exemple d'une fréquence de 433, 92 MHz) et d'un signal Q de commande.

Dans l'exemple illustré sur cette figure, le signal Q de commande est généré par des moyens indépendants de l'oscillateur 1 (circuit numérique 2 de faible consommation). Ce signal Q pourrait également être généré par des moyens intégrés à l'oscillateur 1 et dans ce dernier cas, le circuit numérique 2 piloterait l'alimentation de l'oscillateur 1.

Le transistor T1 est un transistor NPN monté en base commune.

On utilise pour le polariser le signal de commande Q, de sorte que lorsque ce signal de commande Q n'est pas présent, ce transistor T1 n'est pas polarisé.

Il en résulte une optimisation de la consommation.

Ceci permet en outre des temps d'établissement très faibles (moins de 10 µS ou inférieurs) pour l'oscillateur 1.

Ainsi que l'illustre la figure 3, le signal de commande Q est utilisé comme signal d'échantillonnage. Il est présent toutes les 6ms sur des fenêtres temporelles de 100 µs sous la forme d'un signal Quench périodique, qui est par exemple un signal carré dont le rapport cyclique est égal à ½.

Il en résulte une division de la consommation par 60.

A titre d'exemple, le signal Quench est un signal d'une fréquence de 400 KHz, régulé à 2V± 50 mV, ce qui équivaut à la superposition d'un signal de Quench à une tension continue de 1V.

Le montage représenté sur la figure 2 va maintenant être décrit de façon détaillée.

L'émetteur du transistor T1 est relié à la masse par l'intermédiaire d'une résistance R1 montée en parallèle avec un condensateur C1. Son collecteur est relié par une inductance L1 à un point alimenté à une tension Vcc continue. Un condensateur C2 est monté entre le collecteur et l'émetteur de ce transistor T1.

En outre, la base de ce transistor T1 est reliée par une résistance R2 à une borne d'alimentation sur laquelle le circuit numérique 2 injecte le signal de commande Q. La base de ce transistor T1 est également reliée par l'intermédiaire d'un condensateur de couplage C3 à une borne pour son alimentation par le signal RF, laquelle est par ailleurs reliée à la masse par l'intermédiaire d'un condensateur C4.

L'inductance L1, les condensateurs C1, C2 et la résistance R1 définissent, avec le transistor T1, l'oscillateur 1 super-réaction.

On notera que le temps d'établissement du régime de fonctionnement de l'oscillateur 1 est très court. Il dépend essentiellement de la valeur capacitive des condensateurs C3 et C4.

En sortie de l'oscillateur 1 est monté un filtre 3 passe haut schématisé sur la figure par un condensateur de couplage C5 et une inductance L2 montée entre la masse et ledit condensateur C5.

Le signal en sortie dudft filtre 3 passe haut est transmis par un condensateur de couplage C6 à un démodulateur qui comporte un étage 4 à transistor, ainsi qu'un étage 5 à amplificateurs et comparateurs.

On notera que l'étage 4 pourrait avantageusement avoir une fonction amplification en plus de son rôle de démodulation. A -cet effet, une résistance serait placée entre son alimentation et son collecteur et le signal de sortie serait prélevé sur le collecteur.

Le filtre passe-haut 3 permet d'éviter d'utiliser les amplificateurs basse fréquence habituellement utilisés en sortie de l'étage oscillateur dans les récepteurs à super-réaction connus de l'état de la technique. Ces amplificateurs basse fréquence risqueraient en effet d'être saturés lors de la polarisation de l'étage oscillateur.

Le démodulateur que constitue l'étage 4 permet quant à lui d'éviter d'avoir à utiliser un filtre 3 présentant une fréquence de coupure basse, ce qui nécessiterait pour ce filtre 3 des composants d'un encombrement trop important pour être intégrés dans une télécommande.

Le filtre 3 passe-haut a par exemple une fréquence de coupure de l'ordre de 100 MHz et est facilement réalisable avec des composants discrets de petites dimensions.

L'étage 4 de démodulation comporte un transistor T2 NPN dont la base est reliée au condensateur de couplage C6, ainsi qu'à un pont diviseur comportant une résistance R3 montée entre la masse et ladite base et une résistance R4 montée entre une alimentation à la tension Vcc et ladite base. Le collecteur de ce transistor T3 est relié à l'alimentation à la tension Vcc. Son émetteur est relié à la masse par l'intermédiaire d'une résistance R5 montée en parallèle avec un condensateur de filtrage C7.

L'étage 5 comporte quant à lui un amplificateur et un comparateur à hysterésis à amplificateur opérationnels. La sortie de l'étage de démodulation 4 est reliée, par l'intermédiaire d'un condensateur de couplage C8 en série avec une résistance R6, à l'entrée inverseuse d'un amplificateur opérationnel 6 monté en amplificateur inverseur. L'entrée non inverseuse de cet amplificateur 6 est reliée à la masse. Sa sortie est reliée à son entrée inverseuse par l'intermédiaire d'une résistance R7.

Elle est également reliée à l'entrée inverseuse d'un deuxième amplificateur opérationnel 7 monté en bascule de Schmitt, dont l'entrée non inverseuse est reliée à une borne d'alimentation à la tension Vcc par une résistance R7, ainsi qu'à la masse par une résistance R8, une résistance R9 étant montée entre la sortie et l'entrée non inverseuse de cet amplificateur opérationnel 7.

La sortie de ce comparateur est par exemple injectée en entrée du circuit numérique 2.

L'étage 5 est réalisé avec des circuits classiques du commerce dont la consommation est très faible (<5µA).

Le récepteur ainsi réalisé a une consommation moyenne inférieure à 10 µA.

D'autres variantes de réalisation de l'invention sont bien entendu possibles. En particulier, la sortie de l'oscillateur 1 pourrait être réalisée par le collecteur du transistor T1, ce qui permet notamment d'éliminer le filtre 3 passe haut.

Les récepteurs du type de ceux qui viennent d'être décrits sont avantageusement intégrés dans un dispositif pour la commande « mains libres », à distance, du verrouillage et/ou déverrouillage d'au moins un ouvrant de véhicule. Le signal en sortie du récepteur sert alors par exemple à réveiller le cas échéant l'émission par ledit dispositif d'un signal qui porte un code d'authentification destiné à commander le verrouillage/déverrouillage du véhicule. Ce réveil intervient lorsque le récepteur de la télécommande détecte un signal radio-fréquence émis par le véhicule, par exemple après détection de la présence d'un individu à proximité d'une portière ou du coffre du véhicule.

## Revendications

1. Récepteur radio-fréquence comportant un oscillateur (1) qui comprend un transistor (T1) qui est commandé par la superposition d'un signal périodique de commande (Q) qui déclenche périodiquement le démarrage puis la disparition des oscillations de l'oscillateur (1), ainsi que d'un signal haute fréquence (RF) à détecter, caractérisé en ce que le signal périodique (Q) ne commande le transistor que pendant des fenêtres temporelles, qui sont séparées entre elles par des intervalles de temps d'une durée plus importante pendant lesquels le transistor est bloqué.

2. Récepteur selon la revendication 1, caractérisé en ce que le signal périodique de commande (Q) est généré par des moyens (2) externes à l'oscillateur (1).

3. Récepteur selon l'une des revendications précédentes, caractérisé en ce que le transistor (T1) est polarisé par le signal périodique de commande (Q).

4. Récepteur selon la revendication 3, caractérisé en ce que le signal périodique de commande (Q) est une tension dont le niveau moyen est de 2 Volts.

5. Récepteur selon la revendication 4, caractérisé en ce que les variations du signal de commande (Q) sont inférieures à ± 50 mV autour de 2 V.

6. Récepteur selon l'une des revendications précédentes, caractérisé en ce qu'il comporte un filtre passe haut (3) en sortie de l'oscillateur (1).

7. Récepteur selon l'une des revendications précédentes, caractérisé en ce qu'il comporte des moyens (4, 5) formant démodulateur, amplificateur et compensateur en sortie du filtre passe-haut (3).

8. Récepteur selon l'une des revendications précédentes, caractérisé en ce qu'il comporte un circuit numérique (2) qui réalise la génération du signal de commande.

9. Récepteur selon l'une des revendications précédentes, caractérisé en ce qu'une fenêtre temporelle a une durée de l'ordre de 100 µs, un intervalle de temps entre deux fenêtres temporelles ayant une durée de l'ordre de 6 ms.

10. Dispositif pour la commande « mains libres », à distance, du verrouillage et/ou déverrouillage d'au moins un ouvrant de véhicule automobile, comportant des moyens pour l'émission d'un signal qui porte un code destiné à être authentifié par des moyens de réception sur le véhicule, caractérisé en ce qu'il comporte un récepteur selon l'une des revendications précédentes.
